# EUROPÄISCHE PATENTSCHRIFT

(11) **EP 2 774 184 B1**
(45) Veröffentlichungstag und Bekanntmachung des Hinweises auf die Patenterteilung: **04.01.2023**
(21) Anmeldenummer: 12794178.9
(22) Anmeldetag: 05.11.2012
(51) Int. Cl.: H01L 31/0224, H01L 31/18

(54) **VERFAHREN UND VORRICHTUNG ZUR ERZEUGUNG EINER LASERGESTÜTZTEN ELEKTRISCH LEITFÄHIGEN KONTAKTIERUNG EINER OBJEKTOBERFLÄCHE**
METHOD AND DEVICE FOR PRODUCING A LASER-SUPPORTED ELECTRICALLY CONDUCTIVE CONTACT OF AN OBJECT SURFACE
PROCÉDÉ ET DISPOSITIF POUR RÉALISER UNE MISE EN CONTACT ÉLECTROCONDUCTRICE, ASSISTÉE PAR LASER, D'UNE SURFACE D'OBJET

(30) Priorität: 03.11.2011 DE 102011085714
(43) Veröffentlichungstag der Anmeldung: 10.09.2014
(73) Patentinhaber: HEGLA boraident GmbH & Co. KG, 37688 Beverungen (DE)
(72) Erfinder: SCHMUTZ, Wolfgang, Zimmern ob Rottweil (DE); RAINER, Thomas, 38855 Wernigerode (DE); PLAT, Kristin, 06118 Halle (DE); KÜRBITZ, Steffen, 06120 Halle (DE)
(74) Vertreter: Dr. Solf & Zapf Patent- und Rechtsanwalts PartG mbB
(86) Internationale Anmeldenummer: PCT/EP2012/004596
(87) Internationale Veröffentlichungsnummer: WO 2013/064267

(56) Entgegenhaltungen:
- EP-A2- 0 331 022
- DE-A1-102008 057 228
- US-A- 6 060 127

## Beschreibung

Die vorliegende Erfindung bezieht sich auf ein Verfahren zur elektrischen Kontaktierung einer Oberfläche eines Objektes, vorzugsweise einer Solarzelle, nach dem Oberbegriff des Anspruchs 1 sowie auf eine Vorrichtung zur Durchführung des Verfahrens nach dem Oberbegriff des Anspruchs 13.

### Stand der Technik

Die elektrische Kontaktierung von Objektoberflächen, insbesondere von Oberflächen fotovoltaischer Elemente, wie Dünn- und Dickschicht-Solarzellen, ist in vielfältiger Form bekannt.

EP 0 331 022 A2 offenbart beispielsweise ein Verfahren, bei dem leitfähiges Material auf eine Glasoberfläche mittels Laser übertragen wird.

Beispielsweise besteht ein Verfahren darin, leitfähige Pasten in flüssiger Phase durch Druckverfahren, wie Dispensen, InkJet-Druck, Siebdruck, Laser-Transfer-Printing, auf die betreffende Oberfläche aufzubringen und danach zur Überführung von der flüssigen Phase in die feste Phase thermisch induziert auszuhärten, womit eine Fixierung des leitfähigen Pastenmaterials auf der halbleitenden Oberfläche der Solarzelle zur elektrischen Kontaktierung der Solarzelle verbunden ist. Diese Druckverfahren bestehen im Wesentlichen aus zwei Verfahrensschritten, dem Aufbringen der flüssigen Leitpaste und der thermisch aktivierten Aushärtung der Paste. Diese Schritte werden chronologisch wie beispielsweise beim Siebdruckverfahren oder nahezu gleichzeitig wie beispielsweise beim Laser-Transfer-Printing ausgeführt.

Beide vorgenannten Verfahrensschritte besitzen jedoch nachteilige Eigenschaften. Bei dem Auftragen der Leitpaste in der flüssigen Phase auf die Oberfläche von Solarzellen spielt die Benetzbarkeit der Solarzellenoberfläche eine entscheidende Rolle. Deshalb müssen den Leitpasten Stoffe zur Haftvermittlung und Einstellung der Oberflächenspannung zusätzlich beigefügt werden, damit im nachfolgenden thermischen Fixierungsvorgang eine innige Verbindung zwischen Paste und Solarzellenoberfläche entsteht. Solche Zusatzstoffe verteuern jedoch die Leitpasten.

Des Weiteren ist der Auftrag der Leitpaste in der flüssigen Phase auf die Oberfläche von Solarzellen aufgrund der physikalischen Eigenschaft der Oberflächenspannung der Pasten hinsichtlich der Erzeugung minimaler Strukturbreiten und -höhen begrenzt. So ist es nach dem Stand der Technik nicht möglich, Strukturen mit einer Breite von beispielsweise < 100 µm und Höhen bzw. Auftragsdicken < 20 µm herzustellen. Dies ist insbesondere deswegen nachteilig, da durch das Aufbringen der Strukturen die fotoaktive Fläche abgedeckt wird und dieser Bereich nicht zur Umwandlung der Strahlungsenergie der Sonne in elektrische Energie genutzt werden kann. Somit begrenzen diese bekannten Druckverfahren den Wirkungsgrad einer Solarzelle, da je Dickschichtzelle beispielsweise bis zu 60 Leiterbahnen mit Breiten von mindestens 100 µm aufgebracht werden, welches eine nicht unerhebliche Reduzierung der fotoaktiven Fläche bedeutet.

Das thermische Aushärten der flüssigen Leitpasten ist im Falle bspw. des Siebdruckverfahrens ein energieintensiver Schritt, der die Herstellungskosten einer Solarzelle negativ beeinflusst. Dieser Schritt ist beispielsweise beim Laser-Transfer-Printing vorteilhafter, da er hier nur örtlich begrenzt notwendig ist und quasi parallel zum Druck ausgeführt wird. Hierbei ist jedoch aufgrund des Flüssiganteils in der Leitpaste ein relativ hoher Energieeintrag der Laserstrahlung notwendig, um den Flüssiganteil in eine gasförmige Phase zu überführen. Jedoch ist die Laserstrahlung nicht ausreichend, so dass eine anschließende Wärmebehandlung notwendig ist. Dies führt zu einem engen Prozessfenster der Laserparameter, da bei diesem Energieeintrag bereits nahe der Abtrags- und Zerstörschwelle des Solarzellenmaterials gearbeitet werden muss. Somit ist die Steuerung des Prozesses aufwändig und kann bei Versagen der Steuerung möglicherweise zur dauerhaften Schädigung des Solarzellenmaterials führen.

Aufgabe der vorliegenden Erfindung ist es deshalb, ein Verfahren bzw. eine Vorrichtung zur Durchführung des Verfahrens zur elektrischen Kontaktierung beliebiger Objektoberflächen, insbesondere solcher von Solarzellen bereitzustellen, bei dem bzw. der die Kontaktierung in einem Prozessschritt ausgeführt wird und die bei Auftrag von flüssigen Leitpasten sich ergebende Beschränkung in der Strukturbreite nicht besteht.

Zur Lösung dieser Aufgabe sind bei einem Verfahren zur elektrischen Kontaktierung einer Oberfläche eines Objektes der genannten Art die im Anspruch 1 angegebenen Merkmale und bei einer Vorrichtung zur Durchführung des Verfahrens zur elektrischen Kontaktierung einer Oberfläche eines Objektes die im Anspruch 13 angegebenen Merkmale vorgesehen.

Durch die erfindungsgemäßen Maßnahmen wird erreicht, dass die elektrische Kontaktierung mit Hilfe des Laserstrahles in einem einzigen Prozessschritt durchgeführt werden kann und ein anschließender Wärmebehandlungsschritt entfällt. Eine optimale Fokussierung des Laserstrahles ermöglicht geringere Auftrags-bzw. Strukturbreiten der elektrischen Kontaktierung als nach dem bisherigen Stand der Technik bekannt sind.

Auf diese Weise kann der Wirkungsgrad bei der Anwendung des Verfahrens auf der Oberfläche bspw. einer Solarzelle für diese erhöht werden.

Vorteilhafte Ausgestaltungen können gemäß den Merkmalen nach einem oder mehreren der abhängigen Ansprüche vorgesehen sein, womit erreicht ist, dass Material unmittelbar oder aus dem Schichtsystem heraus auf die zu kontaktierende Objektoberfläche übertragen und dort als leitfähige Matrix oder als geschlossene Schicht bzw. Auftrag übertragen wird.

Es kann vorgesehen sein, dass der Laserstrahl in einer Trajektorie geführt werden, welche die zumindest 2¬dimensionale Form der Kontaktierung auf der zu kontaktierenden Oberfläche definiert. Der Laserstrahl kann dabei kontinuierlich betrieben sein oder auch gepulst, wobei sich in letzteren Fall eine Trajektorie aus einer Vielzahl von Punkten zusammensetzt, an welchen jeweils wenigstens ein Laserpuls zur Anwendung kommt.

Da hier bevorzugt das Material von dem Trägerelement gemäß der gefahrenen Trajektorie auf die Oberfläche eines Objektes, z.B. Substrates übertragen wird, kann das Verfahren als eine Art Laserdruck bezeichnet werden.

Bei einem Verfahren kann es vorgesehen sein, dass das Trägerelement bei der Übertragung gegenüber der Oberfläche des zu kontaktierenden Objektes bzw. dem Objekt selbst ortsfest angeordnet ist, sich also bei der Übertragung relativ zu diesem nicht bewegt und der Laserstrahl schreibend relativ zu Trägerelement und Objekts geführt wird.

Es ist vorgesehen, dass der Laser relativ zum Objekt bzw. dessen Oberfläche geführt wird, wobei beim Übertragungsprozess das zu übertragende Material des Trägerelementes am Ort des Laserstrahles kontinuierlich oder synchron, insbesondere synchron zu Laserpulsen, erneuert wird, nämlich durch Verschiebung des Trägerelementes relativ zum Laserstrahl. Hierbei wird ein Trägerelement, insbesondere in der Form eines Bandes mit dem Laserstrahl mitgeführt.

Als Trägerelement kann ein aufgespultes Spenderband dienen, das beim Übertragungsprozeß abgespult wird, insbesondere hierbei durch den Laserstrahl geführt wird, wodurch der Laserstrahl immer wieder während der Übertragung einen neuen unverbrauchten Spenderbandbereich bestrahlt oder durchstrahlt und das bestrahlte / durchstrahlte Material auf die Oberfläche des Objektes überträgt.

Eine weitere vorteilhafte Ausgestaltung des Verfahrens besteht in der Spezialanwendung für Glasscheiben im Architekturbereich als Einbruchschutz. Dabei werden elektrische Schaltungen, wie die sogenannten "Alarmspinnen" auf das Glas mittels Laser aufgetragen. Bei einem Bruch des Glases wird die elektrische Verschaltung unterbrochen und die Alarmanlage wird aktiviert.

Die Vorteile des Verfahrens bzw. der Vorrichtung zur Laser-Kontaktierung von Objektoberflächen sind die Durchführung der Kontaktierung in einem kostenarmen Verfahrensschritt bei gleichzeitiger Verringerung der minimalen Strukturbreite und -höhe, die durch die Eigenschaft des fokussierten Laserstrahls begrenzt werden. Weiterhin entfällt ein nachträglicher, kostenintensiver Wärmeprozess.

Bei dem Verfahren ergibt sich, dass das Material "gerichtet" verdampft oder photoablativ aus der Schicht des Trägerelementes herausgelöst wird und durch die mittels Laserstrahl eingetragene Energie auf die zu beschichtende Oberfläche beschleunigt wird und sich als leitfähiger Auftrag bzw. als geschlossene leitfähige Schicht auf der zu kontaktierenden Oberfläche ablagert, insbesondere nicht nur aus Metallen sondern auch aus Metalloxiden, Übergangsmetallen, Halbleitern, Isolatoren oder dergleichen und auch auf sehr unterschiedlichen Objekten bzw. Substraten, wie beispielsweise Glas, Keramik, Kunststoff, Metall, Verbundwerkstoff oder dergleichen abscheidet und dauerhaft haftet. So kann eine Übertragung auch erfolgen, wenn das Trägerelement die zu kontaktierende Oberfläche nicht berührt, sondern in einem Abstand angeordnet ist, z. B. von wenigen Nanometern oder Mikrometern. Das Material kann in Form von Partikeln aus einer jeweiligen Schicht durch den Laserstrahl herausgelöst und übertragen werden.

Die Schichtdicke der leitfähigen Strukturen bzw. Schichten hängt von den Bestrahlungsbedingungen und dem verwendeten Material ab. Beispielsweise durch die Führungsgeschwindigkeit des Laserstrahls und/oder Verweildauer des Laserstrahls an einem Ort und/oder die Pulsanzahl und/oder die zur Anwendung an einem Ort gekommene Gesamtintensität kann eine Beeinflussung der Dicke erzielt werden.

Die auf den Oberflächen erzeugten leitfähigen Strukturen sind gegenüber Wasser, Lösungsmitteln, Haushaltschemikalien sowie UV-Strahlung beständig. Sie widerstehen Temperaturen von mehreren 100°C.

Vorzugsweise werden zur Erstellung einer Kontaktierung gemäß diesem Verfahren leitfähige und/oder halbleitende Schichten auf Substratoberflächen erzeugt. Es kann auch vorgesehen sein zum Zweck der Kontaktierung Schichten oder Schichtbereiche, insbesondere unter oder um leitende Schichten / Schichtbereiche herum, die aus nicht leitendem Material erzeugt sind, das von dem genannten Trägerelement übertragen wird.

Das Trägerelement kann entweder aus einem kompakten leitfähigen Material oder aus einer Materialkombination beispielsweise einer Kunststofffolie und einer Metallschicht bestehen. Weiterhin kann das Trägerelement beispielsweise eine silber- oder molybdänhaltige Schicht mit geringer Dicke aufweisen. Solche Schichten sind ideal für die Durchführung des Verfahrens geeignet, da sie nur wenig leitfähiges Material benötigen. Im Vergleich zu herkömmlichen Silber-Leitpasten können so Kosten gesenkt werden.

Zusätzlich können mit dem erfindungsgemäßen Laserprozess Schutzschichten gleichzeitig oder nachträglich auf die erzeugten lasergestützten Strukturen aufgetragen werden. Diese Schichten können als Antikorrosionsschichten gegen Umwelteinflüsse und/ oder und zur Erhöhung der Abrieb- und Kratzfestigkeit aufgetragen werden.

Die reine Metallschicht als bevorzugte Variante des erfindungsgemäßen Verfahrens muss nur mit dem Substrat bzw. Objekt in Kontakt oder im Abstand unmittelbar davon gebracht werden und die Laserbestrahlung dann auf die Metallschicht gerichtet werden, insbesondere durch das Trägermaterial für die Metallschicht also zum Beispiel einer PET-Folie hindurch. Eine formbare Folie als Trägerelement kann vorteilhaft auch bei gewölbten Objektoberflächen verwendet werden.

Ist das zu kontaktierende Objekt bei der Laserwellenlänge absorptionsfrei bzw. genügend schwach absorbierend, kann die Laserstrahlung auch durch das Objekt hindurch auf das Schichtsystem gerichtet werden. Für manche Zwecke kann es auch nützlich sein, dass der unmittelbare Kontakt von Schichtsystem und Objektoberfläche, beispielsweise der Solarzellenoberfläche, nicht erforderlich ist.

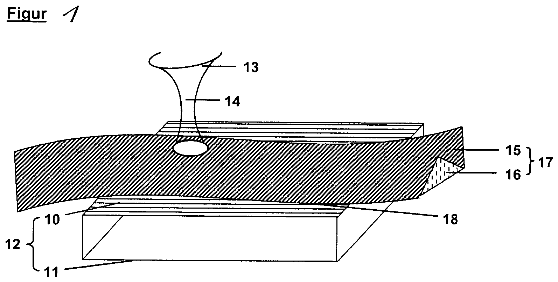

Weitere Einzelheiten der Erfindung sind der folgenden Beschreibung zu entnehmen, in der die Erfindung anhand des in der Zeichnung dargestellten Ausführungsbeispiels näher beschrieben und erläutert ist.

Die einzige Figur zeigt in schematischer Darstellung ein Verfahren zur elektrischen Kontaktierung der Oberfläche eines Objektes, hier einer Silizium-Solarzelle gemäß einem bevorzugten Ausführungsbeispiel vorliegender Erfindung.

Das in der Figur dargestellte Verfahren dient der elektrischen Kontaktierung einer Oberfläche 10 einer Silizium-Solarzelle 12. Das Verfahren besitzt eine nicht dargestellte Auflage, auf der die Silizium-Solarzelle 12 mit ihrer Rückseitenfläche 11 aufgelegt wird. Beim dargestellten Ausführungsbeispiel ist in einem Abstand oberhalb der mit einer leitfähigen Struktur zu versehenden Oberfläche 10 der Silizium-Solarzelle 12 eine Laservorrichtung 13 angeordnet, die einen fokussierbaren Laserstrahl 14 zur Oberfläche 10 der Silizium-Solarzelle 12 gerichtet abgeben kann.

Gemäß dem dargestellten Ausführungsbeispiel ist in einem geringen Abstand 18 zur elektrisch zu kontaktierenden Oberfläche 10 der Silizium-Solarzelle 12 ein Trägerelement 17 gehalten, das der Oberfläche 10 der Silizium-Solarzelle 12 zugewandt mit einer elektrisch leitenden Metallschicht 16, beispielsweise einer Silberschicht belegt ist. Der genannte geringe Abstand 18 ist als Abstand zwischen der Oberfläche 10 der Silizium-Solarzelle 12 und der Unterseite der Metallschicht 16 gegeben.

Bei einem nicht dargestellten weiteren Ausführungsbeispiel vorliegender Erfindung liegt das Trägerelement 17 mit der Unterseite seiner Metallschicht 16 unmittelbar auf der Oberfläche 10 der Silizium-Solarzelle 12 auf.

Das Trägerelement 17 kann beispielsweise als starres Element oder als flexible oder formbare Trägerfolie 15 zur Anpassung an nicht ebene elektrisch zu kontaktierende Oberflächen 10 ausgebildet sein.

Gemäß der zeichnerischen Darstellung ist der fokussierte Laserstrahl 14 der Laservorrichtung 13 auf das mit der Metallschicht 16 versehene Trägerelement 17 gerichtet, derart, dass die darunterliegende Oberfläche 10 der Silizium-Solarzelle 12 zu dem mit der leitfähigen Auflage bzw. Schicht der elektrischen Kontaktierung zu versehenden Bereich der Oberfläche 10 der Silizium-Solarzelle 12 entsprechend angeordnet ist. Der Laserstrahl 14 ist also durch die Trägerfolie 15 hindurch auf die Metallschicht 16 gerichtet und wird dort in der hier als Silberschicht ausgebildeten Metallschicht 16 absorbiert. Durch die Einstrahlung des Laserstrahls 14 wird zumindest metallisches bspw. Silbermaterial auf die zu kontaktierende Oberfläche 10 der Silizium- Solarzelle 12 übertragen.

Diese Verfahrensweise ergibt sich auch dann, wenn, wie vorstehend erwähnt, die Metallschicht 16 der Trägerfolie 15 unmittelbar auf der Oberfläche 10 der Silizium-Solarzelle 12 aufliegt.

In nicht dargestellter Weise kann die reine Metallschicht 16 durch ein Schichtsystem aus Kunststoffmaterial ersetzt sein, in welchem eine Metallschicht 16 eingebettet ist.

Bei einer bevorzugten Ausführungsform wird von der Laservorrichtung 13 ein Laserstrahl 14 mit gaußförmigem Intensitätsprofil bspw. eines gepulsten Nd:YAG-Lasers auf ein bspw. in unmittelbarem Kontakt mit der Trägerelementfläche befindliches Metallschichtsystem 16 fokussiert. Bereits durch einen einzigen Impuls kann eine leitende kreisförmige Fläche (Pixel) erzeugt werden. Der Durchmesser kann zum Beispiel durch den Grad der Fokussierung des Laserstrahls 14 variiert werden. Die leitenden Pixel lassen sich durch eine Relativbewegung zwischen dem Laserstrahl 14 und dem mit der Metallschicht 16 versehenen Trägerelement 17 zu einer beliebigen geschlossenen Schicht bzw. Auftrag zusammensetzen.

Für die Erfindung sind jegliche Schichtsysteme 16 auf starren oder flexiblen bzw. formbaren Trägerelementen 17 einsetzbar, auf dem die Metallschicht 16 oder ein Schichtsystem 16 mit wenigstens einem Metall oder Halbleiter oder Isolator sich befindet, die in den weiteren Schichten des Schichtsystems 16 eingebettet ist. Für die Schicht kommen Metalle wie z. B. Kupfer oder Silber, Metalloxide wie z. B. Zinndioxid, Zinkoxid, Wismutoxid, Übergangsmetalle wie z. B. Molybdän und dergleichen in Frage, aus denen bei der Laserstrahlbehandlung das Matrixmaterial gebildet wird. Hierbei können auch mehrere Schichten aus unterschiedlichen Metallen und/oder Metalloxiden und/oder Übergangsmetalle, Halbleitern und/oder Isolatoren unmittelbar oder in einem Schichtsystem 16 vorhanden sein, was zu einer Einstellung der Leitfähigkeit der Schichten genutzt werden kann.

Gemäß einem weiteren nicht dargestellten Ausführungsbeispiel der Vorrichtung ist es bei elektrisch zu kontaktierenden transparenten Objekten 12 möglich, die Laservorrichtung 13 der Rückseitenfläche 11 des Objektes 12 zugewandt in einem Abstand anzuordnen, so dass der Laserstrahl 14 durch das transparente Objekt 12 und die elektrisch zu kontaktierende Objektoberfläche 10 hindurch auf das Schichtsystem 16 unter dem Trägerelement 17 gerichtet wird. Auch bei dieser Ausgestaltung wird metallisches Material als elektrisch leitfähige Schicht bzw. Auflage auf die Objektoberfläche 10 gebracht bzw. übertragen.

In nicht dargestellter Weise können entsprechend der gewählten Fokussierung des Laserstrahles 14 Partikel aus einer oder mehreren der elektrisch leitfähigen und/oder halbleitenden und/oder isolierenden Schichten insbesondere nacheinander herausgelöst und übertragen werden.

Neben der Anwendung bei Solarzellen ist eine weitere Anwendung bei Sicherheitsgläsern. Auf deren Oberfläche werden mit Hilfe des genannten Verfahrens "gedruckte" Schaltungen aufgebracht.

## Patentansprüche

1. Verfahren zur elektrischen Kontaktierung einer Oberfläche (10) eines Objektes (12), mittels eines von einer Laservorrichtung (13) abgegebenen Laserstrahls (14), wobei in einem Abstand (18) zur Oberfläche (10) des Objekts (12) ein Trägerelement (17) angeordnet wird, das auf seiner der Oberfläche (10) des Objektes (12) zugewandten Seite eine elektrisch leitfähige und/oder eine halbleitende und/oder eine isolierende Schicht (16) trägt, und wobei der vorzugsweise fokussierte Laserstrahl (14) entweder unmittelbar auf das mit der Schicht (16) versehene Trägerelement (17) oder bei für die Laserwellenlänge transparent zu kontaktierenden Objekten (12) durch das für die Laserwellenlänge transparente Objekt (12) hindurch auf das Trägerelement (17) gerichtet wird, wobei aufgrund der Einstrahlung des Laserstrahls (14) Material aus der elektrisch leitfähigen und/oder der halbleitenden und/oder der isolierenden Schicht (16) auf den mit einer elektrischen Kontaktierung zu versehenden Bereich der Oberfläche (10) des Objekts (12) übertragen wird,
**dadurch gekennzeichnet, dass**
die Laservorrichtung (13) relativ zum Objekt (12) geführt wird, wobei das Trägerelement (17) mit der Bewegung der Laservorrichtung (13) mitgeführt wird, und wobei das Trägerelement (17) bei der Bewegung des Laserstrahls (14) relativ zum Laserstrahl (14) aktiv verschoben wird, wobei beim Übertragungsprozess das zu übertragende Material des Trägerelements (17) am Ort des Laserstrahls (14) kontinuierlich oder synchron erneuert wird durch die Verschiebung des Trägerelements (17) relativ zum Laserstrahl (14), und wobei das Trägerelement (17) durch ein aufgespultes Spenderband gebildet wird, welches beim Übertragungsprozess abgespult wird.

2. Verfahren nach Anspruch 1,
**dadurch gekennzeichnet, dass**
eine Schicht aus elektrisch leitfähigem und/oder halbleitendem und/oder isolierendem Material von dem Material des Trägerelementes (17) unterschiedlich ist.

3. Verfahren nach einem der vorherigen Ansprüche,
**dadurch gekennzeichnet, dass**
es unter Umgebungsluft und Umgebungsdruckbedingungen durchgeführt wird, die am Ort der Verfahrensanwendung in der Erdatmosphäre ohne apparative Beeinflussung vorherrschen.

4. Verfahren nach einem der vorherigen Ansprüche,
**dadurch gekennzeichnet, dass**
die zumindest zweidimensionale geometrische Form der Kontaktierung, insbesondere Leiterbahnen, auf der mit der Kontaktierung zu versehenden Oberfläche (10) definiert wird durch eine Trajektorie, auf welcher der Laserstrahl (14) bei der Übertragung geführt wird, insbesondere wobei durch die Führungsgeschwindigkeit und/oder Verweildauer des Laserstrahls (14) an einem Ort die Dicke der Kontaktierung beeinflusst wird.

5. Verfahren nach einem der vorherigen Ansprüche,
**dadurch gekennzeichnet, dass**
das Übertragen erfolgt durch einen Eintrag von Energie in die Schicht (16) mittels des Laserstrahls (14), wodurch Partikel aus der Schicht (16) photoablativ oder durch gerichtete Verdampfung vom Trägerelement (17) gelöst und durch die eingetragene Energie in Richtung zur zu kontaktierenden Oberfläche (10) beschleunigt werden.

6. Verfahren nach einem der vorherigen Ansprüche,
**dadurch gekennzeichnet, dass**
die Schicht (16), welche durch den Laserprozess eine leitfähige Kontaktierung ergibt, auf die betreffende Seite des Trägerelements (17) unmittelbar aufgebracht wird.

7. Verfahren nach einem der vorherigen Ansprüche,
**dadurch gekennzeichnet, dass**
das Trägerelement (17) selbst eine Leitfähigkeit oder vor dem Laserprozess selbst keine Leitfähigkeit aufweist.

8. Verfahren nach einem der vorherigen Ansprüche,
**dadurch gekennzeichnet, dass**
die Leitfähigkeit des Kontaktierungsbereiches beliebig eingestellt wird, insbesondere dadurch, dass die Leitfähigkeit auf der zu kontaktierenden Objektoberfläche (10) gezielt durch die Konzentration von leitfähigem Material eingestellt wird, so dass Bereiche mit hoher bzw. niedrigerer Leitfähigkeit auf der zu kontaktierenden Objektoberfläche (10) erzeugt werden.

9. Verfahren nach mindestens einem der vorhergehenden Ansprüche,
**dadurch gekennzeichnet, dass**
beliebige Schaltungen des Kontaktierungsbereiches erzeugt werden, und/oder sich die erzeugten Strukturen des Kontaktierungsbereiches in beliebig vielen Schichten überlagern und anlagern.

10. Verfahren nach mindestens einem der vorhergehenden Ansprüche,
**dadurch gekennzeichnet, dass**
neben der elektrisch leitfähig erzeugten Struktur gleichzeitig oder nachträglich eine Antikorrosionsschicht beispielsweise mittels Laser aufgetragen wird.

11. Verfahren nach mindestens einem der vorhergehenden Ansprüche,
**dadurch gekennzeichnet, dass**
die elektrisch leitfähige und/oder die halbleitende und/oder die isolierende Schicht (16) des Trägerelements (17) in mindestens eine weitere Schicht eingebettet wird und dass durch die Einstrahlung des Laserstrahls (14) eine Matrix oder eine geschlossene Schicht aus elektrisch leitfähigem und/oder halbleitendem und/oder isolierendem Material insbesondere in Form von Partikeln und Substanzen der mindestens einen weiteren Schicht auf den betreffenden Bereich der Oberfläche (10) des Objekts (12) übertragen wird.

12. Verfahren nach mindestens einem der vorhergehenden Ansprüche,
**dadurch gekennzeichnet, dass**
durch Auswahl der Bestrahlungsparameter, insbesondere von Impulsdauer, Impulsenergie, Fokussierung des Laserstrahles (14) und/oder Relativgeschwindigkeit zwischen Objektoberfläche (10) und Laserstrahl (14) auf die Dimension und auf den Wert der elektrischen Leitfähigkeit des elektrischen Kontaktierungsbereichs Einfluss genommen wird, insbesondere dadurch, dass bei der Lasereinstrahlung ein Abstand (18) von der elektrisch leitfähigen und/oder halbleitenden und/oder isolierenden Schicht oder der mindestens einen weiteren Schicht zur Objektoberfläche (10) in einem zwei- bis dreistelligen nm-Bereich oder direkt in Kontakt gewählt wird.

13. Vorrichtung zur Durchführung des Verfahrens zur elektrischen Kontaktierung einer Oberfläche (10) eines Objektes (12), nach einem der vorherigen Ansprüche, mit einer Laservorrichtung (13), wobei in einem Abstand (18) zur Oberfläche (10) des Objekts (12) ein Trägerelement (17) angeordnet ist, das auf seiner der Oberfläche (10) des Objekts (12) zugewandten Seite unmittelbar oder mittelbar eine elektrisch leitfähige und/oder eine halbleitende und/oder eine isolierende Schicht (16) trägt, und wobei der vorzugsweise fokussierte Laserstrahl (14) entweder unmittelbar auf das mit der elektrisch leitfähigen und/oder der halbleitenden und/oder der isolierenden Schicht (16) versehene Trägerelement (17) oder für die Laserwellenlänge transparente zu kontaktierende Objekte (12) durch das für die Laserwellenlänge transparente Objekt (12) auf das Trägerelement (17) gerichtet ist,
**dadurch gekennzeichnet, dass**
die Vorrichtung eingerichtet ist, die Laservorrichtung (13) relativ zum Objekt (12) zu führen, und dabei das Trägerelement (17) bei der Bewegung des Laserstrahls (14) relativ zum Laserstrahl (14) aktiv zu verschieben, wobei beim Übertragungsprozess das zu übertragende Material des Trägerelements (17) am Ort des Laserstrahls (14) kontinuierlich oder synchron erneuerbar ist durch die Verschiebung des Trägerelements (17) relativ zum Laserstrahl (14), und die Vorrichtung eingerichtet ist, das Trägerelement (17) in der Form eines Bandes mit der Bewegung der Laservorrichtung (13) mitzuführen.

14. Vorrichtung nach Anspruch 13,
**dadurch gekennzeichnet, dass**
das Trägerelement (17) eine formbare Folie oder ein flexibles Substrat ist.

15. Vorrichtung nach Anspruch 13 oder 14,
**dadurch gekennzeichnet, dass**
mindestens eine elektrisch leitfähige oder halbleitende oder isolierende Schicht (16) in einem Schichtsystem (15, 16) auf dem Trägerelement (17) eingebettet ist.

## Claims

1. Method for electrically contacting a surface (10) of an object (12) by means of a laser beam (14) emitted by a laser device (13), wherein a carrier element (17) is arranged at a distance (18) from the surface (10) of the object (12), which carrier element carries an electrically conductive and/or a semiconductive and/or an insulating layer (16) on its side facing the surface (10) of the object (12), and wherein the preferably focused laser beam (14) is directed either directly onto the carrier element (17) provided with the layer (16) or, in the case of objects (12) to be contacted transparently for the laser wavelength, through the object (12) transparent for the laser wavelength onto the carrier element (17), wherein, due to the irradiation of the laser beam (14), material from the electrically conductive and/or the semiconductive and/or the insulating layer (16) is transferred to the region of the surface (10) of the object (12) to be provided with electrical contacting,
**characterized in that**
the laser device (13) is moved relative to the object (12), wherein the carrier element (17) is carried along with the movement of the laser device (13), and wherein the carrier element (17) is actively displaced relative to the laser beam (14) during the movement of the laser beam (14), wherein during the transferring process the material of the carrier element (17) to be transferred is renewed continuously or synchronously at the location of the laser beam (14) by the displacement of the carrier element (17) relative to the laser beam (14), and wherein the carrier element (17) is formed by a wound donor tape which is unwound during the transferring process.

2. Method according to claim 1,
**characterized in that**
a layer of electrically conductive and/or semiconductive and/or insulating material is different from the material of the carrier element (17).

3. Method according to one of the preceding claims,
**characterized in that**
it is carried out under ambient air and ambient pressure conditions which prevail at the place of application of the method in the earth's atmosphere without any influence by apparatus.

4. Method according to one of the preceding claims,
**characterized in that**
the at least two-dimensional geometric shape of the contacting, in particular conductor tracks, on the surface (10) to be provided with the contacting is defined by a trajectory on which the laser beam (14) is guided during transferring, in particular wherein the thickness of the contacting is influenced by the movement speed and/or exposure time of the laser beam (14) at one location.

5. Method according to one of the preceding claims,
**characterized in that**
the transferring takes place by introducing energy into the layer (16) by means of the laser beam (14), whereby particles are detached from the layer (16) photoablatively or by directed evaporation from the carrier element (17) and accelerated by the introduced energy in the direction of the surface (10) to be contacted.

6. Method according to one of the preceding claims,
**characterized in that**
the layer (16), which results in a conductive contacting by the laser process, is applied directly to the respective side of the carrier element (17).

7. Method according to one of the preceding claims,
**characterized in that**
the carrier element (17) itself has conductivity or, prior to the laser process, itself has no conductivity.

8. Method according to one of the preceding claims,
**characterized in that**
the conductivity of the contacting region is set as desired, in particular by specifically setting the conductivity on the object surface (10) to be contacted by the concentrating of conductive material, so that regions with high or lower conductivity are produced on the object surface (10) to be contacted.

9. Method according to at least one of the preceding claims,
**characterized in that**
any circuits of the contacting area are generated, and/or the generated structures of the contacting area are superimposed and accumulated in any number of layers.

10. Method according to at least one of the preceding claims,
**characterized in that**
in addition to the electrically conductively generated structure, an anti-corrosion layer is applied simultaneously or subsequently, for example by means of a laser.

11. Method according to at least one of the preceding claims,
**characterized in that**
the electrically conductive and/or the semiconductive and/or the insulating layer (16) of the carrier element (17) is embedded in at least one further layer, and that a matrix or a closed layer of electrically conductive and/or semiconductive and/or insulating material, in particular in the form of particles and substances of the at least one further layer, is transferred to the respective region of the surface (10) of the object (12) by the irradiation of the laser beam (14).

12. Method according to at least one of the preceding claims,
**characterized in that**
by selecting the irradiation parameters, in particular pulse duration, pulse energy, focusing of the laser beam (14) and/or relative velocity between object surface (10) and laser beam (14), the dimension and the value of the electrical conductivity of the electrical contacting region is influenced, in particular **in that**, during the laser irradiation, a distance (18) from the electrically conductive and/or semiconductive and/or insulating layer or the at least one further layer to the object surface (10) is selected in a two- to three-digit nm range or directly in contact.

13. Device for carrying out the method for electrically contacting a surface (10) of an object (12), according to one of the previous claims, with a laser device (13), wherein, at a distance (18) from the surface (10) of the object (12), a carrier element (17) is arranged, which directly or indirectly carries an electrically conductive and/or a semiconductive and/or an insulating layer (16) on its side facing the surface (10) of the object (12), and wherein the preferably focused laser beam (14) is directed either directly onto the carrier element (17) provided with the electrically conductive and/or the semiconductive and/or the insulating layer (16), or, in the case of objects (12) to be contacted that are transparent for the laser wavelength, through the object (12) transparent for the laser wavelength onto the carrier element (17),
**characterized in that**
the device is arranged to guide the laser device (13) relative to the object (12), and in so doing to actively displace the carrier element (17) relative to the laser beam (14) during the movement of the laser beam (14), wherein, during the transferring process, the material to be transferred of the carrier element (17) at the location of the laser beam (14) is continuously or synchronously renewable by the displacement of the carrier element (17) relative to the laser beam (14), and the device is arranged to carry the carrier element (17) in the form of a belt along with the movement of the laser device (13).

14. Device according to claim 13,
**characterized in that**
the carrier element (17) is a formable foil or a flexible substrate.

15. Device according to claim 13 or 14,
**characterized in that**
at least one electrically conductive or semiconductive or insulating layer (16) is embedded in a layer system (15, 16) on the carrier element (17).

## Revendications

1. Procédé pour réaliser une mise en contact électrique d'une surface (10) d'un objet (12), au moyen d'un faisceau laser (14) émis par un dispositif laser (13), dans lequel un élément support (17) est agencé à une distance (18) de la surface (10) de l'objet (12), lequel porte sur son côté tourné vers la surface (10) de l'objet (12) une couche (16) électroconductrice et/ou une couche semi-conductrice et/ou une couche isolante, et dans lequel le faisceau laser (14) de préférence focalisé est directement dirigé sur l'élément support (17) pourvu de la couche (16) ou pour des objets (12) à mettre en contact de manière transparente pour la longueur d'onde laser à travers l'objet (12) transparent pour la longueur d'onde laser sur l'élément support (17), dans lequel en raison de l'incidence du faisceau laser (14), du matériau de la couche (16) électroconductrice et/ou de la couche semi-conductrice et/ou de la couche isolante est transmis à la zone à pourvoir d'une mise en contact électrique de la surface (10) de l'objet (12),
**caractérisé en ce que**
le dispositif laser (13) est guidé par rapport à l'objet (12), dans lequel l'élément support (17) est entraîné avec le mouvement du dispositif laser (13), et dans lequel l'élément support (17) est déplacé activement lors du mouvement du faisceau laser (14) par rapport au faisceau laser (14), dans lequel lors du processus de transmission, le matériau à transmettre de l'élément support (17) est renouvelé à l'endroit du faisceau laser (14) en continu ou de manière synchrone par le déplacement de l'élément support (17) par rapport au faisceau laser (14), et dans lequel l'élément support (17) est formé par une bande de distributeur enroulée qui est déroulée lors du processus de transmission.

2. Procédé selon la revendication 1,
**caractérisé en ce que**
une couche de matériau électroconducteur et/ou semi-conducteur et/ou isolant est différente du matériau de l'élément support (17).

3. Procédé selon l'une quelconque des revendications précédentes,
**caractérisé en ce que**
il est réalisé sous air ambiant et dans des conditions de pression ambiante qui règnent à l'endroit de l'application du procédé dans l'atmosphère terrestre sans influence d'appareil.

4. Procédé selon l'une quelconque des revendications précédentes,
**caractérisé en ce que**
la forme géométrique au moins en deux dimensions de la mise en contact, en particulier des pistes conductrices, est définie sur la surface (10) à pourvoir de la mise en contact par une trajectoire, sur laquelle le faisceau laser (14) est guidé lors de la transmission, en particulier dans lequel l'épaisseur de la mise en contact est influencée par la vitesse de guidage et/ou la durée de séjour du faisceau laser (14).

5. Procédé selon l'une quelconque des revendications précédentes,
**caractérisé en ce que**
la transmission est effectuée par un apport d'énergie dans la couche (16) au moyen du faisceau laser (14), par quoi des particules de la couche (16) sont dissoutes de manière photo-ablative ou par évaporation dirigée de l'élément support (17) et sont accélérées par l'énergie apportée en direction de la surface à mettre en contact (10).

6. Procédé selon l'une quelconque des revendications précédentes,
**caractérisé en ce que**
la couche (16) qui produit par le processus laser une mise en contact conductrice est directement appliquée sur le côté concerné de l'élément support (17).

7. Procédé selon l'une quelconque des revendications précédentes,
**caractérisé en ce que**
l'élément support (17) présente lui-même une conductivité ou avant le processus laser ne présente lui-même aucune conductivité.

8. Procédé selon l'une quelconque des revendications précédentes,
**caractérisé en ce que**
la conductivité de la zone de mise en contact est réglée de manière quelconque, en particulier du fait que la conductivité soit réglée de manière ciblée sur la surface de l'objet (10) à mettre en contact par la concentration de matériau conducteur de sorte que des zones avec une conductivité élevée ou plus faible soient générées sur la surface de l'objet à mettre en contact (10).

9. Procédé selon au moins l'une quelconque des revendications précédentes,
**caractérisé en ce que**
des circuits quelconques de la zone de mise en contact sont générés, et/ou les structures générées de la zone de mise en contact se chevauchent et s'accumulent dans de nombreuses couches quelconques.

10. Procédé selon au moins l'une quelconque des revendications précédentes,
**caractérisé en ce que**
une couche anticorrosion est appliquée simultanément ou ultérieurement par exemple au moyen du laser à côté de la structure générée de manière électroconductrice.

11. Procédé selon au moins l'une quelconque des revendications précédentes,
**caractérisé en ce que**
la couche (16) électroconductrice et/ou la couche semi-conductrice et/ou la couche isolante de l'élément support (17) est intégrée dans au moins une autre couche et que par l'incidence du faisceau laser (14), une matrice ou une couche fermée de matériau électroconducteur et/ou semi-conducteur et/ou isolant est transmise en particulier sous la forme de particules et de substances d'au moins une autre couche sur la zone concernée de la surface (10) de l'objet (12).

12. Procédé selon au moins l'une quelconque des revendications précédentes,
**caractérisé en ce que**
par sélection des paramètres d'irradiation, en particulier de durée d'impulsion, énergie d'impulsion, focalisation du faisceau laser (14) et/ou vitesse relative entre la surface de l'objet (10) et le faisceau laser (14) une influence est exercée sur la dimension et sur la valeur de la conductivité électrique de la zone de mise en contact électrique, en particulier du fait que pour l'incidence du laser, une distance (18) de la couche électroconductrice et/ou semi-conductrice et/ou isolante ou de ladite au moins une autre couche à la surface de l'objet (10) est choisie dans une zone nm à deux ou trois chiffres ou directement en contact.

13. Dispositif de réalisation du procédé pour la mise en contact électrique d'une surface (10) d'un objet (12) selon l'une quelconque des revendications précédentes, avec un dispositif laser (13), dans lequel un élément porteur (17) est agencé à une distance (18) de la surface (10) de l'objet (12), lequel porte sur son côté tourné vers la surface (10) de l'objet (12) directement ou indirectement une couche (16) électroconductrice et/ou une couche semi-conductrice et/ou une couche isolante, et dans lequel le faisceau laser (14) de préférence focalisé est dirigé directement sur l'élément support (17) pourvu de la couche électroconductrice et/ou la couche semi-conductrice et/ou la couche isolante (16) ou pour les objets (12) à mettre en contact transparents pour la longueur d'onde laser à travers l'objet (12) transparent pour la longueur d'onde laser sur l'élément support (17),
**caractérisé en ce que**
le dispositif est conçu afin de guider le dispositif laser (13) par rapport à l'objet (12), et de déplacer activement l'élément support (17) lors du mouvement du faisceau laser (14) par rapport au faisceau laser (14), dans lequel lors du processus de transmission, le matériau à transmettre de l'élément support (17) est renouvelable à l'endroit du faisceau laser (14) en continu ou de manière synchrone par le déplacement de l'élément support (17) par rapport au faisceau laser (14), et le dispositif est conçu afin d'entraîner l'élément support (17) sous la forme d'une bande avec le mouvement du dispositif laser (13).

14. Dispositif selon la revendication 13,
**caractérisé en ce que**
l'élément support (17) est un film formable ou un substrat flexible.

15. Dispositif selon la revendication 13 ou 14,
**caractérisé en ce que**
au moins une couche électroconductrice ou semi-conductrice ou isolante (16) est intégrée dans un système de couches (15, 16) sur l'élément support (17).
